# EUROPÄISCHE PATENTSCHRIFT

(11) **EP 3 036 832 B1**
(45) Veröffentlichungstag und Bekanntmachung des Hinweises auf die Patenterteilung: **19.12.2018**
(21) Anmeldenummer: 14747905.9
(22) Anmeldetag: 31.07.2014
(51) Int. Cl.: H03K 17/18, H03K 17/082

(54) **VERFAHREN ZUM SCHÜTZEN EINES STEUERBAREN HALBLEITERSCHALTERS GEGEN ÜBERLAST UND KURZSCHLUSS IN EINEM LASTKREIS**
METHOD FOR PROTECTING A CONTROLLABLE SEMICONDUCTOR SWITCH FROM OVERLOAD AND SHORT-CIRCUITING IN A LOAD CIRCUIT
PROCÉDÉ DE PROTECTION D'UN COMMUTATEUR À SEMI-CONDUCTEUR COMMANDABLE CONTRE LES SURCHARGES ET LES COURTS-CIRCUITS DANS UN CIRCUIT DE CHARGE

(30) Priorität: 20.08.2013 DE 102013216492
(43) Veröffentlichungstag der Anmeldung: 29.06.2016
(73) Patentinhaber: Conti Temic Microelectronic GmbH, 90411 Nürnberg (DE)
(72) Erfinder: JOOS, Uli, 88149 Nonnenhorn (DE); PÖLZER, Alexander, 88682 Salem (DE); SPECKNER, Martin, 85095 Denkendorf (DE); STUHLER, Norbert, 88212 Ravensburg (DE)
(74) Vertreter: Bonn, Roman Klemens
(86) Internationale Anmeldenummer: PCT/EP2014/066456
(87) Internationale Veröffentlichungsnummer: WO 2015/024754

(56) Entgegenhaltungen:
- DE-A1- 19 735 543
- DE-A1-102011 003 733
- US-A1- 2011 002 073

## Beschreibung

Die Erfindung betrifft ein Verfahren zum Schützen eines steuerbaren Halbleiterschalters gegen Überlast und Kurzschluss in einem Lastkreis, insbesondere ein Verfahren zum Schutz von Halbleiter-Endstufen bei der Ansteuerung von Gleichstrommotoren.

DE 19735543A1, US2011/002073A1 und DE102011003733A1 erläutern Lastschutzvorrichtungen.

Das Dokument DE19735543 offenbart ein Verfahren zum Schützen eines steuerbaren Halbleiterschalters gegen Überlast und Kurzschluss in einem Lastkreis, wobei das Verfahren folgende Schritte aufweist: - Erfassen einer Ausgangsspannung des Halbleiterschalters; - Vergleichen einer erfassten Ausgangsspannung mit einem prognostizierten Schaltfortschritt; - Deaktivieren des Halbleiterschalters, falls die erfasste Ausgangsspannung kleiner als der prognostizierte Schaltfortschritt ist.

Gleichstrommotoren in Kraftfahrzeugen werden für gewöhnlich mithilfe von Relais oder Halbleiterschaltern angesteuert. Dabei wird von einer Reihenschaltung aus einem Halbleiterschalter und einem Motor als induktiver Last ausgegangen, bei der der Halbleiterschalter von einer Steuerung, beispielsweise einer PWM Steuerung, mittels Steuersignale ein- und ausschaltbar, das heißt steuerbar ist.

Wird ein derartiger Halbleiterschalter in einem Kraftfahrzeug eingesetzt, müssen der Halbleiterschalter sowie der Motor dabei gegen Kurzschluss beziehungsweise Überlastung geschützt werden, um einen katastrophalen Ausfall zu verhindern.

Ein Ansatz hierzu besteht in der Verwendung von so genannten "intelligenten" Halbleiterschaltern, wobei, basierend auf Strom- und/oder Temperaturmessungen, der Fehlerzustand durch eine in den Schalter integrierter Elektronik erfasst und der Halbleiterschalter durch geeignete Maßnahmen geschützt wird. Derartige "intelligente" Halbleiterschalter sind jedoch vergleichsweise teuer und deshalb für preissensitive Applikationen unakzeptabel.

Für gewöhnlich werden vielmehr Standard Leistungshalbleiter, so genannte Power-MOSFETS, als Halbleiterschalter verwendet, deren Schutz im Fehlerfall jedoch wesentlich problematischer ist, da die wesentlichen physikalischen Größen Drain Strom und Junction Temperatur nicht direkt gemessen werden können ist.

Ein weiterer Ansatz besteht darin, in Reihe mit dem steuerbaren Halbleiterschalter, welcher einen Lastkreis, insbesondere einen Motor betätigt, eine Schmelzsicherung zu schalten. Dies hat jedoch den entscheidenden Nachteil, dass Schmelzsicherungen äußerst träge sind und nach dem Auftreten einer Überlast oder eines Kurzschlusses im Lastkreis die Sicherung zerstört ist und ausgewechselt werden muss.

Bekannt ist auch die Möglichkeit einer Strombegrenzung durch geeignete Beschaltung des steuerbaren Halbleiterschalters. Durch eine solche Strombegrenzung wird zwar verhindert, dass ein unzulässig hoher Strom durch den steuerbaren Halbleiter fließen kann. Im Falle einer Überlast oder eines Kurzschlusses im Lastkreis tritt jedoch an dem steuerbaren Halbleiterschalter eine hohe Verlustleistung auf, die nur durch geeignete große Kühlflächen abgeführt werden kann. In den meisten Fällen ist die Anbringung einer großen Kühlfläche an der Schalteinrichtung jedoch aus Platzgründen nicht möglich. Im Wesentlichen wird folglich die Strombegrenzungsschaltung nur dann angewandt, wenn nur Lastströme von wenigen Milliampere auftreten.

Aus der Druckschrift DE 35 19 791 C2 ist eine Schutzschaltung für einen steuerbaren Halbleiterschalter gegen Überlast und Kurzschluss in einem Lastkreis bekannt, wobei eine Messschaltung vorgesehen ist, welche sowohl mit dem Lastkreis als auch mit einer Überwachungsschaltung in Verbindung steht. Dabei wird der Strom im Lastkreis gemessen, beispielsweise über den Spannungsabfall an einem niedrigohmigen Widerstand. Übersteigt der Strom einen eingestellten Grenzwert, wird der den Lastkreis schaltende steuerbare Halbleiter abgeschaltet. Nach einer bestimmten Zeit, wird der steuerbare Halbleiter dann wieder durchgeschaltet. Dabei wird ein Messstrom erzeugt, welcher im Lastkreis nach Abschalten des steuerbaren Halbleiterschalters fließt und von der Messschaltung ausgewertet wird. Dieser Messstrom wird solange durch den Lastkreis geschickt, bis der Widerstand im Lastkreis einen Nennwiderstand erreicht hat. Bei Erreichen des Nennwiderstandes wird die Überwachungsschaltung zumindest im Hinblick auf das Aufheben der Abschaltung des steuerbaren Halbleiterschalters so beeinflusst, dass dieser wieder durchgeschaltet wird.

Als nachteilig bei einer derartigen Schutzschaltung erweist sich jedoch, dass die Messungen erst dann erfolgen können, wenn der Schalter sicher vollständig eingeschaltet ist. Liegt aber bereits vor der Einschaltung des Leistungsschalters ein Kurzschluss an, muss der Halbleiterschalter verhältnismäßig lange Zeit im Fehlbetrieb angesteuert werden, bevor die Entscheidung über eine Deaktivierung erfolgen kann. Außerdem ist zur Vermeidung von Fehlauslösung für gewöhnlich eine zeitliche Filterung erforderlich, wodurch die Zeit in der der Halbleiterschalter im Fehlerbetrieb angesteuert wird, weiter verlängert wird. Durch die damit einhergehende lange Verweilzeit im Fehlbetrieb wird der Stress im Bauteil vergleichsweise groß und die Zuverlässigkeit des Halbleiterschalters entsprechend reduziert.

Aufgabe der vorliegenden Erfindung ist es, ein Verfahren zum Schützen eines steuerbaren Halbleiterschalters gegen Überlast und Kurzschluss in einem Lastkreis anzugeben, wobei Reaktionszeiten der Fehlererkennung verkürzt werden können.

Gelöst wird diese Aufgabe durch den Gegenstand der unabhängigen Ansprüche. Weitere vorteilhafte Weiterbildungen sind Gegenstand der abhängigen Ansprüche.

Gemäß einer Ausführungsform wird diese Aufgabe gelöst durch ein Verfahren zum Schützen eines steuerbaren Halbleiterschalters gegen Überlast und Kurzschluss in einem Lastkreis, welches folgende Schritte aufweist: So wird eine Ausgangsspannung des Halbleiterschalters erfasst, eine erfasste Ausgangsspannung mit einem prognostizierten Schaltfortschritt verglichen und, falls die erfasste Ausgangsspannung kleiner als der prognostizierte Schaltfortschritt ist, der Halbleiterschalter deaktiviert.

Das Verfahren beruht folglich auf der Kenntnis beziehungsweise der Prognose des Schaltvorganges. Der prognostizierte Schaltfortschritt kann dabei insbesondere eine aus einer Kennlinie des Halbleiterschalters, welche einen prognostizierten Verlauf der Ausgangsspannung über die Zeit angibt, gelesene, zu erreichende Schwellspannung sein. Grundgedanke ist dabei, basierend auf dieser Prognose den Schaltvorgang des Halbleiterschalters spannungsmäßig zu erfassen und mit einem Sollprofil zu vergleichen.

Ein derartiges Verfahren hat den Vorteil, dass die Reaktionszeiten der Fehlererkennung beim Schützen eines steuerbaren Halbleiterschalters gegen Überlast und Kurzschluss in einem Lastkreis erheblich verkürzt werden können. Da das Verfahren dabei auf der Kenntnis beziehungsweise der Prognose des Schaltvorgangs basiert und nicht auf der Messung des Spannungsabfalls im Einschaltzustand beruht, kann das Verfahren auch zum Einsatz kommen, wenn der Halbleiterschalter noch nicht vollständig eingeschaltet ist. Dies erweist sich vor allem dann als vorteilhaft, wenn der Fehler bereits vor dem Einschalten des Halbleiterschalter anliegt, folglich die Zeit bis zur Entscheidung über die Deaktivierung des Halbleiterschalters bei Verfahren, welche auf der Messung des Spannungsabfalls im eingeschalteten Zustand beruhen, besonders lang werden würde. Wird dabei die detektiert, dass die erfasste Ausgangsspannung einen prognostizierten Schaltfortschritt erreicht, bleibt der Halbleiterschalter eingeschaltet. Wird jedoch detektiert, dass der prognostizierte Schaltfortschritt nicht erreicht wird, das heißt dass ein Fehler anliegt, wird der Halbleiterschalter entsprechend deaktiviert.

Bevorzugt werden die Schritte des Erfassens einer Ausgangsspannung und des Vergleichens der erfassten Ausgangsspannung mit dem prognostizierten Schaltfortschritt wenigstens einmal durchgeführt, bevor der Halbleiterschalter vollständig eingeschaltet ist. Der Zeitpunkt der Überprüfung kann hierbei vorgebbar sein. Hierdurch kann gewährleistet werden, dass auch Fehler, welche bereits vor dem Einschalten des Halbleiterschalters anliegen, beispielsweise dass der Halbleiterschalter beim Einschalten mit einer Überlast betrieben wird, detektiert werden können und die Reaktionszeit der Fehlererkennung somit erheblich verkürzt werden kann, wodurch weiter der Stress im Halbleiterschalter minimiert wird.

Gemäß einer Ausführungsform werden die Schritte des Erfassens einer Ausgangsspannung und des Vergleichens der erfassten Ausgangsspannung mit dem prognostizierten Schaltfortschritt dabei wenigstens einmal wiederholt ausgeführt. Insbesondere kann eine Entscheidung über den Abbruch des Einschaltvorgangs, das heißt die Deaktivierung des Halbleiterschalters, somit vorzugsweise mehrfach erfolgen, bevor der Halbleiterschalter vollständig eingeschaltet ist. Dies hat den Vorteil, dass die Genauigkeit des Verfahrens weiter erhöht werden kann.

Dabei können die Schritte des Erfassens einer Ausgangsspannung sowie des Vergleichens der erfassten Ausgangsspannung mit dem prognostizierten Schaltfortschritt zu zeitlich kaskadierten Zeitpunkten durchgeführt werden. Durch die zeitliche Kaskadierung kann die Entscheidung, ob der Halbleiterschalter deaktiviert wird, zum frühestmöglichen Zeitpunkt des Einschaltens des Halbleiterschalters und damit zum Zeitpunkt mit dem geringsten Stress für den Halbleiterschalter getroffen werden. Zu zeitlich kaskadierten Zeitpunkten bedeutet hierbei, dass die einzelnen Wiederholungen zeitlich nacheinander in geeigneten Abständen durchgeführt werden.

Weiter kann der prognostizierte Schaltfortschritt frei programmierbar sein. Dies bedeutet, dass eine zu erreichende Schwellspannung flexibel an verschiedene Schalter beziehungsweise Einschaltprofile angepasst werden kann, wodurch eine größtmögliche Flexibilität bei der Ansteuerung des Halbleiterschalters erreicht wird.

Zudem kann das Verfahren auch mit den bekannten Verfahren zur Messung des Spannungsabfalls im Einschaltzustand kombiniert werden, um einen bestmöglichen Schutz des Halbleiterschalters bei geringem Ansteueraufwand zu gewährleisten. Hierzu kann das Verfahren insbesondere weiter folgende Schritte aufweisen: So wird ein Strom in einem Lastkreis und/oder ein Spannungsabfall am Halbleiterschalter gemessen sobald der Halbleiterschalter vollständig eingeschaltet ist, der gemessene Strom und/oder der gemessene Spannungsabfall mit einem vorgegebenen Grenzwert verglichen und der Halbleiterschalter anschließend deaktiviert, falls der gemessene Strom und/oder der gemessene Spannungsabfall größer als der vorgegebene Grenzwert sind.

Mit einer weiteren Ausführungsform wird auch eine Schutzschaltung für einen steuerbaren Halbleiterschalter gegen Überlast und Kurzschluss in einem Lastkreis angegeben, welche eine Überwachungsschaltung zum Erfassen einer Ausgangsspannung des Halbleiterschalters, wenigstens einen Komparator zum Vergleichen der erfassten Ausgangsspannung mit einem prognostizierten Schaltfortschritt sowie eine Auswertungslogik zum Deaktivieren des Halbleiterschalters, falls die erfasste Ausgangsspannung kleiner als der vorgegebene Grenzwert ist, umfasst.

Eine derartige Schutzschaltung hat den Vorteil, dass die Reaktionszeiten der Fehlererkennung beim Schützen eines steuerbaren Halbleiterschalters gegen Überlast und Kurzschluss in einem Lastkreis erheblich verkürzt werden können. Unter dem prognostizierten Schaltfortschritt wird hierbei wiederum eine, insbesondere aus einer Kennlinie des Halbleiterschalters, welche einen prognostizierten Verlauf der Ausgangsspannung über die Zeit angibt, gelesene, zu erreichende Schwellspannung verstanden. Da die Schutzschaltung ausgebildet ist, die Überwachung des Halbleiterschalters auf Kenntnis beziehungsweise Prognose des Schaltvorganges zu basieren und nicht auf der Messung von Spannungsabfällen im eingeschalteten Zustand, kann die Schutzschaltung auch dann eingesetzt, das heißt aktiv werden, wenn der Halbleiterschalter noch nicht vollständig eingeschaltet ist. Dies erweist sich vor allem dann als vorteilhaft, wenn der Fehler bereits vor dem Einschalten des Halbleiterschalter anliegt, folglich die Zeit bis zur Entscheidung über die Deaktivierung des Halbleiterschalters bei Schutzschaltungen, welche auf der Messung des Spannungsabfalls im eingeschalteten Zustand basieren, besonders lange werden würde. Detektiert die Schutzschaltung hierbei, dass die erfasste Ausgangsspannung einen prognostizierten Schaltfortschritt erreicht, bleibt der Halbleiterschalter eingeschaltet. Wird jedoch detektiert, dass der prognostizierte Schaltfortschritt nicht erreicht wird, das heißt dass ein Fehler anliegt, wird der Halbleiterschalter entsprechend deaktiviert.

Zudem kann es sich bei der Auswertungslogik um einen digitalen Logikschaltkreis handeln. Derartige Schaltkreise bestehen hauptsächlich aus Logikelementen, wie AND, NAND, OR, NOR, NOT, XOR, XNOR und anderen, mit denen digitale Ja/Nein-Informationen miteinander verknüpft werden, zum Beispiel im Rahmen von Zählern oder Flipflops. Komplexere Anwendungen sind Prozessoren. Auch können diese zusätzlich zu logischen Funktionen auch zeitabhängige Bestandteile enthalten und ferner takt- oder zustandsgesteuert (synchron/asynchron) arbeiten. Vorteile der digitalen Signalverarbeitung gegenüber der analogen Technik liegen, neben den geringeren Kosten der Bauteile aufgrund hoher Integrationsdichte und vereinfachter Entwicklung, vor allem in der höheren Flexibilität. Mit Hilfe spezieller Signalprozessoren oder Computer können Schaltungen in Software realisiert werden. Dadurch lassen sich Funktionen sehr schnell an veränderte Anforderungen anpassen. Außerdem sind komplexe Algorithmen einfach anwendbar, die analog nur mit extrem hohem Aufwand oder gar nicht realisierbar wären. Weiter sind diese einfach zu testen und wird eine schleichende Fehlerfortpflanzung vermieden, wodurch sehr komplexe Systeme realisierbar sind und die verlustfreie Übertragung von Signalen über weite Strecken ermöglicht wird.

Weiter kann die Steuereinheit einen Mikrocontroller aufweisen, welcher eine Datenschnittstelle zum Programmieren des vorgegebenen Schwellwertes aufweist. Unter Mikrocontroller werden allgemein Halbleiterchips verstanden, die einen Prozessor und zugleich auch Peripheriefunktionen enthalten. Auch sind moderne Motorsteuerungen mehr und mehr mit Mikrocontrollern ausgestattet, um die in Echtzeit benötigten Rechenoperation schnell und genau zu verarbeiten. Weiter ermöglicht die Datenschnittstelle, dass eine zu erreichende Schwellspannung flexibel an verschiedene Schalter beziehungsweise Einschaltprofile angepasst werden kann, wodurch eine größtmögliche Flexibilität bei der Ansteuerung des Halbleiterschalters erreicht wird. Insgesamt kann somit eine größtmögliche Flexibilität bei der Ansteuerung des Halbleiterschalters erreicht und weiter der Stress im Halbleiterschalter erheblich reduziert werden.

Bei dem Halbleiterschalter kann es sich dabei insbesondere um einen Leistungs-MOSFET handeln. So werden für gewöhnlich so genannte Standard Leistungshalbleiter, das heißt Leistungs-MOSFETs, als Halbleiterschalter verwendet. Folglich ist mittels einer derartigen Schutzschaltung ein Schutz von standardmäßig verwendeten Halbleiterschaltern mit relativ geringem Ansteueraufwand möglich.

Mit einer weiteren Ausführungsform, wird auch eine Halbbrückenschaltung zum Ansteuern eines Gleichstrommotors angegeben, welche eine oben beschriebene Schutzschaltung aufweist.

Halbbrückenschaltungen werden ganz allgemein zur Erzeugung eines Wechselsignals aus einer eingangsseitig zugeführten Gleichspannung verwendet. Bei entsprechender Verschaltung können derartige Halbbrückenschaltungen auch zur Erzeugung mehrphasiger Wechselsignale, insbesondere auch von dreiphasigen Drehstromsignalen, verwendet werden. Das ausgangsseitige (gegebenenfalls mehrphasige) Wechselsignal wird dann beispielsweise einem Motor zugeführt. Halbbrückenschaltungen basieren dabei im Wesentlichen auf zwei Leistungstransistoren als Halbleiterschalter sowie zwei Dioden, welche üblicherweise jeweils auf einem einzigen Chip integriert sind. Eine derartige Halbbrückenschaltung hat den Vorteil, dass die Reaktionszeiten der Fehlererkennung beim Schützen eines steuerbaren Halbleiterschalters der Halbbrückenschaltung gegen Überlast und Kurzschluss in dem Motor erheblich verkürzt werden können. Unter dem prognostizierten Schaltfortschritt wird hierbei wiederum eine beispielsweise aus einer Kennlinie des Halbleiterschalters, welche einen prognostizierten Verlauf der Ausgangsspannung über die Zeit angibt, gelesene, zu erreichende Schwellspannung verstanden. Da die Schutzschaltung ausgebildet ist, die Überwachung des Halbleiterschalters auf Kenntnis beziehungsweise Prognose des Schaltvorganges zu basieren und nicht auf der Messung von Spannungsabfällen im eingeschalteten Zustand, kann die Schutzschaltung auch dann eingesetzt, das heißt aktiv werden, wenn der Halbleiterschalter noch nicht vollständig eingeschaltet ist. Dies erweist sich vor allem dann als vorteilhaft, wenn der Fehler bereits vor dem Einschalten des Halbleiterschalters anliegt, folglich die Zeit bis zur Entscheidung über die Deaktivierung des Halbleiterschalters bei Schutzschaltungen, welche auf der Messung des Spannungsabfalls im eingeschalteten Zustand basieren, besonders lange werden würde. Detektiert die Schutzschaltung hierbei, dass die erfasste Ausgangsspannung einen prognostizierten Schaltfortschritt erreicht, bleibt der Halbleiterschalter eingeschaltet. Wird jedoch detektiert, dass der prognostizierte Schaltfortschritt nicht erreicht wird, das heißt dass ein Fehler anliegt, wird der Halbleiterschalter entsprechend deaktiviert.

Zusammenfassend ist festzustellen, dass mit der vorliegenden Erfindung ein Verfahren zum Schützen eines steuerbaren Halbleiterschalters gegen Überlast und Kurzschluss in einem Lastkreis angegeben wird, mit welchem die Reaktionszeiten der Fehlererkennung beim Schützen eines steuerbaren Halbleiterschalters gegen Überlast und Kurzschluss in einem Lastkreis erheblich verkürzt werden können.

So kann das Verfahren auch dann angewendet werden, wenn der Halbleiterschalter noch nicht vollständig eingeschaltet ist, da das Verfahren auf Kenntnis beziehungsweise Prognose des Schaltvorgangs basiert und nicht auf der Messung von Spannungsabfällen im eingeschalteten Zustand. Dies erweist sich vor allem dann als vorteilhaft, wenn der Fehler bereits vor dem Einschalten des Halbleiterschalters anliegt, folglich die Zeit bis zur Entscheidung über die Deaktivierung des Halbleiterschalters bei Schutzschaltungen, welche auf der Messung des Spannungsabfalls im eingeschalteten Zustand basieren, besonders lange werden würde.

Auch kann die Flexibilität des Verfahrens erheblich erhöht werden, da der prognostizierte Schaltfortschritt frei programmierbar ist, das heißt dass ein Schaltprofil somit flexibel an verschiedene Schalter angepasst werden kann.

Die Erfindung wird nun anhand der beigefügten Figuren näher erläutert.
- Figur 1: zeigt ein Flussdiagramm eines Verfahrens zum Schützen eines steuerbaren Halbleiterschalters gegen Überlast und Kurzschluss in einem Lastkreis gemäß Ausführungsformen der Erfindung;
- Figur 2: zeigt ein Ersatzschaltbild einer Schutzschaltung zum Schützen eines steuerbaren Halbleiterschalters gegen Überlast und Kurzschluss in einem Lastkreis gemäß Ausführungsformen der Erfindung;
- Figur 3: zeigt in einem Spannungs-Zeit Diagramm den Ablauf eines Verfahrens zum Schützen eines steuerbaren Halbleiterschalters gegen Überlast und Kurzschluss in einem Lastkreis gemäß Ausführungsformen der Erfindung, wobei der Halbleiterschalter beim Einschalten mit einer Überlast betrieben wird.

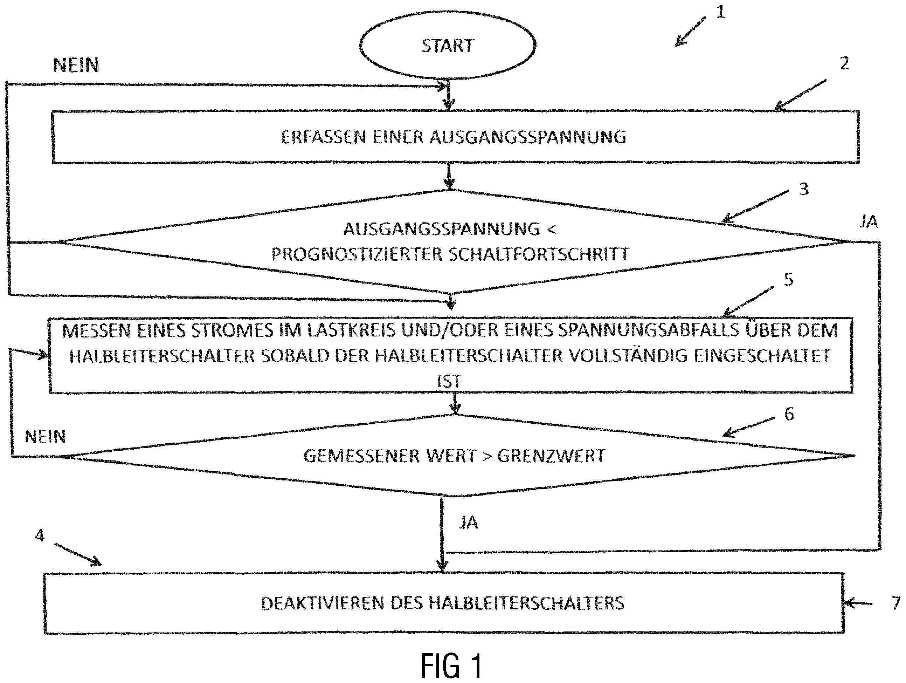

Figur 1 zeigt ein Flussdiagramm eines Verfahrens 1 zum Schützen eines steuerbaren Halbleiterschalters gegen Überlast und Kurzschluss in einem Lastkreis gemäß Ausführungsform der Erfindung.

Wie Figur 1 zeigt, weist das Verfahren 1 dabei folgende Schritte auf: So wird in einem Schritt 2 eine Ausgangsspannung des Halbleiterschalters erfasst, in einem Schritt 3 die erfasste Ausgangsspannung mit einem prognostizierten Schaltfortschritt verglichen und der Halbleiterschalter anschließend in einem Schritt 4 deaktiviert, falls die erfasste Ausgangsspannung kleiner als der prognostizierte Schaltfortschritt ist. Unter dem prognostizierten Schaltfortschritt wird hierbei wiederum eine beispielsweise aus einer Kennlinie des Halbleiterschalters, welche einen prognostizierten Verlauf der Ausgangsspannung über die Zeit angibt, gelesene, zu erreichende Schwellspannung verstanden.

Da das Verfahren 1 gemäß Figur 1 auf der Kenntnis beziehungsweise der Prognose des Schaltvorgangs basiert und nicht auf der Messung des Spannungsabfalls im Einschaltzustand beruht, kann das Verfahren auch zum Einsatz kommen, wenn der Halbleiterschalter noch nicht vollständig eingeschaltet ist. Dies erweist sich vor allem dann als vorteilhaft, wenn der Fehler bereits vor dem Einschalten des Halbleiterschalters anliegt, folglich die Zeit bis zur Entscheidung über die Deaktivierung des Halbleiterschalters bei Verfahren, welche auf der Messung des Spannungsabfalls im eingeschalteten Zustand beruhen, besonders lang werden würde.

Gemäß der Ausführungsform der Figur 1, werden die Schritte 2 und 3 des Erfassens einer Ausgangsspannung des Halbleiterschalters sowie des Vergleichens der erfassten Ausgangsspannung mit dem prognostizierten Schaltfortschritt wenigstens einmal durchgeführt, bevor der Halbleiterschalter vollständig eingeschaltet ist.

Gemäß den Ausführungsformen der Figur 1 wird das Verfahren während eines Zeitfensters, während dessen die dynamische Überwachung des Halbleiterschalters aktiv ist, derart ausgeführt, dass die Schritte 2 und 3 innerhalb dieses Zeitfensters wenigstens einmal wiederholt werden, falls in einer vorangegangenen Überprüfung in dem Schritt 3 detektiert wurde, dass die Ausgangsspannung den prognostizierten Schaltfortschritt erreicht.

Die Wiederholung oder Wiederholungen der Schritte 2 und 3 werden dabei zu zeitlich kaskadierten Zeitpunkten innerhalb des Zeitfensters durchgeführt. Zu zeitlich kaskadierten Zeitpunkten bedeutet hierbei, dass die einzelnen Schritte zeitlich nacheinander in geeigneten Abständen durchgeführt werden.

Insgesamt ist das Verfahren 1 somit ausgebildet, die Entscheidung über die Deaktivierung des Halbleiterschalters zum frühestmöglichen Zeitpunkt des Einschaltens und damit zum Zeitpunkt mit dem geringsten Stress für den Halbleiterschalter zu treffen.

Wie dargestellt ist, weist das Verfahren 1 zudem den optionalen Schritt 5 eines Messens eines Stroms in dem Lastkreis und/oder eines Spannungsabfalls über dem Halbleiterschalter sobald der Halbleiterschalter vollständig eingeschaltet ist, den Schritt 6 des Vergleichens des gemessenen Wertes mit einem vorgegebenen Grenzwert sowie den Schritt 7 des Deaktivierens des Halbleiterschalters, falls der gemessene Wert größer als der vorgegebene Grenzwert ist, auf. Das Verfahren 1 kann somit mit den bekannten Verfahren zur Messung des Spannungsabfalls im Einschaltzustand kombiniert werden, um einen bestmöglichen Schutz des Halbleiterschalters bei geringem Ansteueraufwand zu gewährleisten, insbesondere weiter auch zuverlässig Fehler detektieren können, welche nicht bereits während des Einschaltvorganges anliegen.

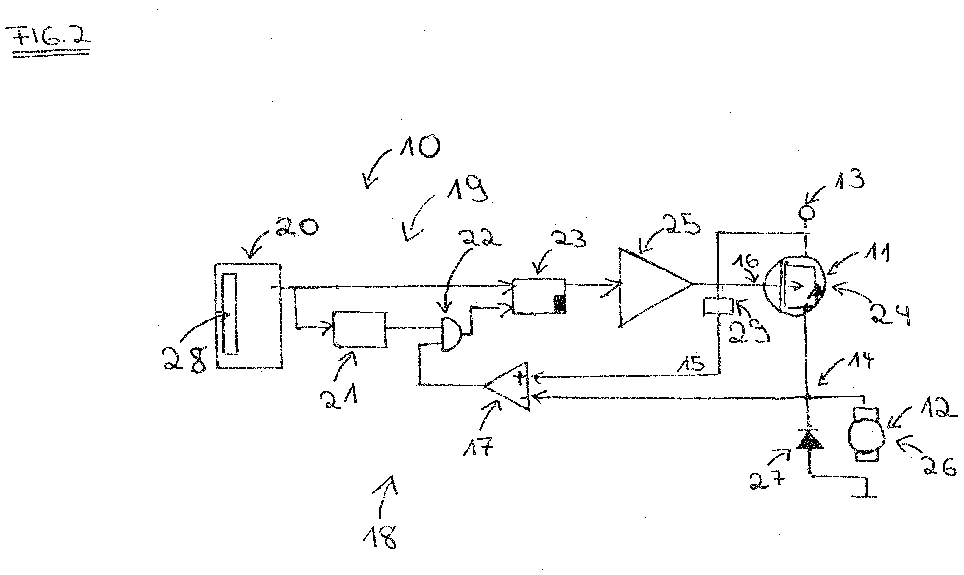

Figur 2 zeigt ein Ersatzschaltbild einer Schutzschaltung 10 zum Schützen eines steuerbaren Halbleiterschalters 11 gegen Überlast und Kurzschluss in einem Lastkreis 12 gemäß Ausführungsform der Erfindung.

Figur 2 zeigt dabei eine Anschlussklemme 13 über welche eine Versorgungsspannung zum Ansteuern des Halbleiterschalters zugeführt wird. An einer weiteren Klemme 14 ist der eigentliche Lastkreis 12 angeschlossen.

Gemäß der Ausführungsform der Figur 2, ist weiter eine Verbindungsleitung 15 von einem Ausgang des Halbleiterschalters 11 zu einem Komparator 17, zum Übermitteln einer, von einer Überwachungsschaltung 29, an dem Ausgang des Halbleiterschalters 11 erfassten beziehungsweise abgegriffenen Ausgangsspannung. Der Komparator 17 gemäß Figur 2 ist weiter ausgebildet, die erfasste Ausgangsspannung mit einem prognostizierten Schaltfortschritt zu vergleichen.

Weiter zeigt Figur 2 eine als digitaler Logikschaltkreis 19 realisierte Auswertungslogik 18. Diese umfasst einen Mikrocontroller 20, eine Zeitglied 21, ein Und-Gatter 22 sowie 25 ein Latch 23. Unter Latch 23 wird allgemein ein Speicherelement verstanden, wobei der Zustand des Speichers durch einen ersten Steuereingang gesetzt beziehungsweise durch einen zweiten Eingang zurückgesetzt wird.

Gemäß den Ausführungsformen der Figur 2 erhält der Latch 23 an seinem Dateneingang ein Ausgangssignal des Mikrocontrollers 20, im Speziellen ein Signal einen Gate Treiber 25 anzuweisen, den Halbleiterschalter 13 ein- bzw. auszuschalten.

An dem zweiten Eingang des Latches 23 liegt ein Signal des Und-Gatters 22 an, dessen Eingangsvariablen digitale Informationen der Regeleinrichtung 21 sowie des Komparators 17 sind. Die Regeleinrichtung 21 ist dabei ausgebildet, digitale Informationen über einen Zeitpunkt eines Vergleichs der erfassten Ausgangsspannung mit dem prognostizierten Schaltfortschritt auszugeben. Das Und-Gatter 22 dient somit dazu, die digitalen Ausgangssignale der Regeleinrichtung 21 und des Komparators 17 miteinander zu verknüpfen.

Wird nun detektiert, dass die erfasste Ausgangsspannung zum gewünschten Zeitpunkt mit dem prognostizierten Schaltfortschritt übereinstimmt, liefert der Ausgang des Und-Gatters 22 den logischen Wert "0" . In diesem Fall bleibt der Zustand des Latches 23 gesetzt und der Halbleiterschalter 13 bleibt somit weiterhin entsprechend der vom Mikrocontroller 20 gelieferten digitalen Informationen angesteuert.

Wird wiederum detektiert, dass die erfasste Ausgangsspannung zum gewünschten Zeitpunkt nicht mit dem prognostizierten Schaltfortschritt übereinstimmt, liefert der Ausgang des Und Gatters 22 den logischen Wert "1". In diesem Fall wird der Zustand des Latches 23 zurückgesetzt und der Halbleiterschalter 13 somit deaktiviert.

Weiter weist der Mikrocontroller 20 der Figur 2 eine Datenschnittstelle 28 auf, mittels welcher der prognostizierte Schaltfortschritt frei programmierbar ist.

Bei dem dargestellten Halbleiterschalter 11 handelt es sich um einen Leistungs-MOSFET 24, welches über einen Gate Treiber 25 angesteuert, insbesondere eingeschaltet wird.

Zudem handelt es sich bei dem gezeigten Lastkreis um einen Gleichstrommotor 26. Auch ist eine zusätzliche Diode 27 zu erkennen, welche dazu dient, den Strom im Leerlauf mit wenigen Verlusten zu führen.

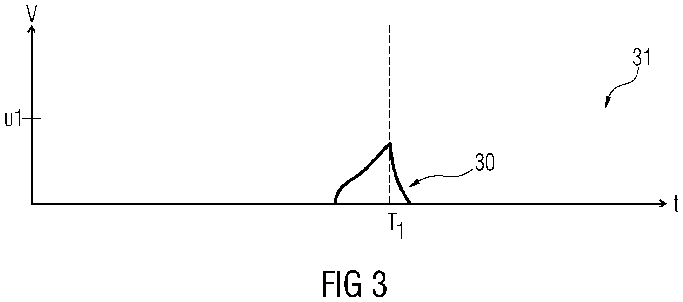

Figur 3 zeigt in einem Spannungs-Zeit Diagramm den Ablauf eines Verfahrens zum Schützen eines steuerbaren Halbleiterschalters gegen Überlast und Kurzschluss in einem Lastkreis gemäß Ausführungsform der Erfindung, wobei der Halbleiterschalter beim Einschalten mit einer Überlast betrieben wird.

Figur 3 zeigt den zeitlichen Verlauf einer erfassten Ausgangsspannung des Halbleiterschalters, sowie einen prognostizierten Schaltfortschritt. Bei den Ausführungsformen gemäß Figur 3 wird die erfasste Ausgangsspannung durch die mit Bezugszeichen 30 gekennzeichnete Linie symbolisiert. Der prognostizierte Schaltfortschritt wird wiederum durch die mit Bezugszeichen 31 gekennzeichnete strichpunktierte Linie symbolisiert.

Wie zu erkennen ist, wird der Halbleiterschalter bereits beim Einschalten mit einer Überlast betrieben. Folglich erreicht die erfasste Ausgangsspannung des Halbleiterschalters zum Entscheidungszeitpunkt T1 nicht den vorgegebenen Schwellwert U1 des prognostizierten Schaltfortschritts. Folglich wird gemäß den dargestellten Ausführungsformen der Halbleiterschalter deaktiviert.

### Bezugszeichenliste

- 1: Verfahren
- 2: Verfahrensschritt
- 3: Verfahrensschritt
- 4: Verfahrensschritt
- 5: Verfahrensschritt
- 6: Verfahrensschritt
- 7: Verfahrensschritt
- 10: Schutzschaltung
- 11: Halbleiterschalter
- 12: Lastkreis
- 13: Anschlussklemme
- 14: weitere Klemme
- 15: Verbindungsleitung
- 17: Komparator
- 18: Auswertungslogik
- 19: digitaler Logikschaltkreis
- 20: Mikrocontroller
- 21: Regeleinrichtung
- 22: UND-Gatter
- 23: Latch
- 24: Power-MOSFET
- 25: Gate Treiber
- 26: Gleichstrommotor
- 27: Diode
- 28: Datenschnittstelle
- 29: Überwachungsschaltung
- 30: Ausgangsspannung
- 31: prognostizierter Schaltfortschritt

## Patentansprüche

1. Verfahren zum Schützen eines steuerbaren Halbleiterschalters in High-End Anordnung gegen Überlast und Kurzschluss in einem Lastkreis, wobei das Verfahren (1) folgende Schritte aufweist:
- Erfassen einer Ausgangsspannung des Halbleiterschalters (2), welche Ausgangsspannung der Spannungsabfall über dem Lastkreis ist;
- Vergleichen einer erfassten Ausgangsspannung mit einem prognostizierten Schaltfortschritt (3) in Form eines Schwellwerts;
- Deaktivieren des Halbleiterschalters, falls die erfasste Ausgangsspannung kleiner als der prognostizierte Schaltfortschritt ist (4),
wobei die Schritte des Erfassens einer Ausgangsspannung (2) sowie des Vergleichens der erfassten Ausgangsspannung mit dem prognostizierten Schaltfortschritt (3) wenigstens einmal wiederholt wird,
und
wobei der prognostizierte Schaltfortschritt frei programmierbar ist.

2. Verfahren nach Anspruch 1, wobei die Schritte des Erfassens einer Ausgangsspannung des Halbleiterschalters (2) sowie des Vergleichens der erfassten Ausgangsspannung mit dem prognostizierten Schaltfortschritt (3) wenigstens einmal durchgeführt werden, bevor der Halbleiterschalter vollständig eingeschaltet ist.

3. Verfahren nach Anspruch 2, wobei die Schritte des Erfassens der Ausgangsspannung (2) sowie des Vergleichens der erfassten Ausgangsspannung mit dem prognostizierten Schaltfortschritt (3) zu zeitlich kaskadierten Zeitpunkten wiederholt werden.

4. Verfahren nach einem der Ansprüche 1 bis 3, wobei das Verfahren (1) weiter folgende Schritte aufweist:
- Messen eines Stroms in dem Lastkreis und/oder eines Spannungsabfalls am Halbleiterschalter, sobald der Halbleiterschalter vollständig eingeschaltet ist (5);
- Vergleichen des gemessenen Stroms und/oder des gemessenen Spannungsabfalls mit einem vorgegebenen Grenzwert (6);
- Deaktivieren des Halbleiterschalters, falls der gemessene Strom und/oder der gemessene Spannungsabfall größer als der vorgegebene Grenzwert ist (7).

5. Schutzschaltung für einen steuerbaren Halbleiterschalter in High-End Anordnung gegen Überlast und Kurzschluss in einem Lastkreis, wobei die Schutzschaltung (10) eine Überwachungsschaltung (29) zum Erfassen einer Ausgangsspannung des Halbleiterschalters (11), wenigstens einen Komparator (17) zum Vergleichen der erfassten Ausgangsspannung mit einem prognostizierten Schaltfortschritt in Form eines Schwellwerts, sowie eine Auswertungslogik (18) zum Deaktivieren des Halbleiterschalters (11), falls die erfasste Ausgangsspannung kleiner als der prognostizierte Schaltfortschritt ist, umfasst,
wobei die Ausgangsspannung der Spannungsabfall über dem Lastkreis ist;
wobei die Schutzschaltung dazu ausgebildet ist, dass Schritte des Erfassens einer Ausgangsspannung (2) sowie des Vergleichens der erfassten Ausgangsspannung mit dem prognostizierten Schaltfortschritt (3) wenigstens einmal wiederholt werden,
und
wobei der prognostizierte Schaltfortschritt frei programmierbar ist.

6. Schutzschaltung nach Anspruch 5, wobei die Auswertungslogik (18) ein digitaler Schaltkreis (19) ist.

7. Schutzschaltung nach Anspruch 5 oder 6, wobei die Schutzschaltung (10) weiter einen Mikrocontroller (20) mit einer Datenschnittstelle (28) zum Programmieren eines prognostizierten Schaltfortschritts aufweist.

8. Schutzschaltung nach einem der Ansprüche 5 bis 7, wobei der Halbleiterschalter ein Leistungs-MOSFET (24) ist.

9. Halbbrückenschaltung zum Ansteuern eines Gleichstrommotors, welche eine Schutzschaltung (10) nach einem der Ansprüche 5 bis 8 aufweist.

## Claims

1. Method for the protection of a controllable semiconductor switch in high-end arrangement against overload and short-circuiting in a load circuit, wherein the method (1) comprises the following steps:
- detection of an output voltage of the semiconductor switch (2), which output voltage is the voltage drop across the load circuit;
- comparison of a detected output voltage with a predicted switching progress (3) in the form of a threshold value;
- deactivation of the semiconductor switch if the detected output voltage is smaller than the predicted switching progress (4),
wherein the steps of detecting an output voltage (2) and of comparing the detected output voltage with the predicted switching progress (3) are repeated at least once, and
wherein the predicted switching progress is freely programmable.

2. Method according to Claim 1, wherein the steps of detecting an output voltage of the semiconductor switch (2) and of comparing the detected output voltage with the predicted switching progress (3) are carried out at least once before the semiconductor switch is fully switched on.

3. Method according to Claim 2, wherein the steps of detecting the output voltage (2) and of comparing the detected output voltage with the predicted switching progress (3) are repeated at cascaded moments in time.

4. Method according to one of Claims 1 to 3, wherein the method (1) comprises the further following steps:
- measuring a current in the load circuit and/or a voltage drop at the semiconductor switch, as soon as the semiconductor switch is fully switched on (5);
- comparing the measured current and/or the measured voltage drop with a specified limit value (6);
- deactivating the semiconductor switch if the measured current and/or the measured voltage drop is larger than the specified limit value (7).

5. Protective circuit for a controllable semiconductor switch in high-end arrangement against overload and short-circuiting in a load circuit, wherein the protective circuit (10) comprises a monitoring circuit (29) for detecting an output voltage of the semiconductor switch (11), at least one comparator (17) for comparing the detected output voltage with a predicted switching progress in the form of a threshold value, as well as evaluation logic (18) for deactivating the semiconductor switch (11) if the detected output voltage is smaller than the predicted switching progress,
wherein the output voltage is the voltage drop across the load circuit;
wherein the protective circuit is configured such that steps of detecting an output voltage (2) and of comparing the detected output voltage with the predicted switching progress (3) are repeated at least once,
and
wherein the predicted switching progress is freely programmable.

6. Protective circuit according to Claim 5, wherein the evaluation logic (18) is a digital circuit (19).

7. Protective circuit according to Claim 5 or 6, wherein the protective circuit (10) further comprises a microcontroller (20) with a data interface (28) for programming a predicted switching progress.

8. Protective circuit according to one of Claims 5 to 7, wherein the semiconductor switch is a power MOSFET (24).

9. Half-bridge circuit for driving a DC motor, which circuit comprises a protective circuit (10) according to one of Claims 5 to 8.

## Revendications

1. Procédé de protection d'un commutateur semiconducteur commandable dans un arrangement haut de gamme contre les surcharges et les courts-circuits dans un circuit de charge, le procédé (1) comprenant les étapes suivantes :
- détection d'une tension de sortie du commutateur semiconducteur (2), ladite tension de sortie étant la chute de tension aux bornes du circuit de charge ;
- comparaison d'une tension de sortie détectée avec une progression de commutation pronostiquée (3) sous la forme d'une valeur de seuil ;
- désactivation du commutateur semiconducteur dans le cas où la tension de sortie détectée est inférieure à la progression de commutation pronostiquée (4),
les étapes de détection d'une tension de sortie (2) et de comparaison de la tension de sortie détectée avec la progression de commutation pronostiquée (3) étant répétées au moins une fois
et
la progression de commutation pronostiquée étant programmable librement.

2. Procédé selon la revendication 1, les étapes de détection d'une tension de sortie du commutateur semiconducteur (2) et de comparaison de la tension de sortie détectée avec la progression de commutation pronostiquée (3) étant exécutées au moins une fois avant que le commutateur semiconducteur soit entièrement mis en circuit.

3. Procédé selon la revendication 2, les étapes de détection de la tension de sortie (2) et de comparaison de la tension de sortie détectée avec la progression de commutation pronostiquée (3) étant répétées à des instants en cascade dans le temps.

4. Procédé selon l'une des revendications 1 à 3, le procédé (1) comprenant en outre les étapes suivantes :
- mesure d'un courant dans le circuit de charge et/ou d'une chute de tension aux bornes du commutateur semiconducteur dès que le commutateur semiconducteur est entièrement mis en circuit (5) ;
- comparaison du courant mesuré et/ou de la chute de tension mesurée avec une valeur limite prédéfinie (6) ;
- désactivation du commutateur semiconducteur dans le cas où le courant mesuré et/ou la chute de tension mesurée sont supérieurs à la valeur limite prédéfinie (7).

5. Circuit de protection pour un commutateur semiconducteur commandable dans un arrangement haut de gamme contre les surcharges et les courts-circuits dans un circuit de charge, le circuit de protection (10) comportant un circuit de surveillance (29) destiné à détecter une tension de sortie du commutateur semiconducteur (11), au moins un comparateur (17) destiné à comparer la tension de sortie détectée avec une progression de commutation pronostiquée sous la forme d'une valeur de seuil, ainsi qu'une logique d'interprétation (18) destinée à désactiver le commutateur semiconducteur (11) dans le cas où la tension de sortie détectée est inférieure à la progression de commutation pronostiquée,
la tension de sortie étant la tension de chute aux bornes du circuit de charge ;
le circuit de protection étant configuré pour répéter les étapes de détection d'une tension de sortie (2) et de comparaison de la tension de sortie détectée avec la progression de commutation pronostiquée (3) au moins une fois et
la progression de commutation pronostiquée étant programmable librement.

6. Circuit de protection selon la revendication 5, la logique d'interprétation (18) étant un circuit numérique (19).

7. Circuit de protection selon la revendication 5 ou 6, le circuit de protection (10) possédant en outre un microcontrôleur (20) pourvu d'une interface de données (28) destinée à la programmation d'une progression de commutation pronostiquée.

8. Circuit de protection selon l'une des revendications 5 à 7, le commutateur semiconducteur étant un MOSFET de puissance (24) .

9. Circuit en demi-pont destiné à exciter un moteur à courant continu, lequel possède un circuit de protection (10) selon l'une des revendications 5 à 8.
